# EUROPEAN PATENT SPECIFICATION

(11) **EP 4 006 938 B1**
(45) Date of publication and mention of the grant of the patent: **11.02.2026**
(21) Application number: 20209819.0
(22) Date of filing: 25.11.2020
(51) Int. Cl.: H01H 33/34, H01H 33/02, H01H 11/00, H01H 9/16, G01R 31/327, H01H 33/40

(54) **MONITOR FOR SWITCHGEAR OR CIRCUIT BREAKERS**
MONITOR FÜR SCHALTANLAGE ODER LEISTUNGSSCHALTER
MONITEUR POUR APPAREILLAGE DE COMMUTATION OU DISJONCTEURS

(43) Date of publication of application: 01.06.2022
(73) Proprietor: Hitachi Energy Ltd, 8050 Zürich (CH)
(72) Inventor: SYKES, Thomas, 8006 Zürich (CH); KOTILAINEN, Sami, 5443 Niederrohrdorf (CH)
(74) Representative: Vossius & Partner Patentanwälte Rechtsanwälte mbB

(56) References cited:
- EP-A1- 3 680 925
- EP-A1- 3 712 919
- WO-A1-2019/197038
- WO-A1-92/01303
- US-A- 5 750 950
- US-A1- 2005 168 891

## Description

The present invention relates to a monitor for switchgear or circuit breakers and a corresponding method. The system and method may particularly be employed for a hydro-mechanical operating mechanism for (high voltage) switchgear.

Circuit breakers or switchgear and particularly hydro-mechanical circuit breakers are used in electrical grids in order to control, protect and isolate electrical equipment. High-voltage switchgear may operate hydro-mechanically, i.e. by a combination of hydraulic pressure and mechanical, e.g. spring, pressure. Details on the working principle will be given below.

Switchgear condition monitoring according to the state-of-the-art varies according to the particular substation and operator from having no monitoring at all, employing warning lamps or installing hardwired systems which are capable of monitoring multiple parameters. However, these advanced hardwired monitoring systems are cumbersome to retrofit since in some cases the entire control cabinet has to be rewired according to customer specification. During this time, the switchgear has to be taken off the grid and thus leads to a costly outage.

It is, however, important to monitor certain switchgear parameters which may be indicative of possible faults such as leakage of a hydraulic system inside the switchgear in order to optimise maintenance and reduce downtime of the system.

WO 92/01303 A1 discloses a device for monitoring a condition of switchgear. EP 3 712 919 A1 discloses an anomaly diagnosis device for an oil-hydraulic operating mechanism. US 5 750 950 A relates to a hydraulic drive device for a circuit breaker. EP 3 680 925 A1 discloses a circuit breaker and a monitoring mechanism. US 2005/168891 A1 relates to a condition monitor for a circuit breaker which is operated by an electric motor. WO 2019/197038 A1 discloses a switchgear comprising sensors.

It is therefore an object of the present invention to provide a non-invasive, retrofittable device for efficiently reliably monitoring switchgear parameters.

This problem is solved by the independent claims defining the invention. The dependent claims describe preferred embodiments.

In particular, the present disclosure relates to a device for monitoring a condition of a hydromechanical switchgear, as defined by the independent claim 1.

Various embodiments may preferably implement the following features:

Preferably, the at least one measured parameter is periodically transmitted.

The transmission means may preferably be configured to wirelessly transmit the at least one measured parameter using Long Range Wireless Transmitter or Bluetooth or a 5G transmission protocol.

The controller is preferably configured to process the at least one measured pump parameter to generate an operational state and/or maintenance state of the hydro-mechanical switchgear.

Preferably, the operational state and/or maintenance state comprises information on at least one of system pressure, leakage detection, sealing state, piston state, pump state, electrical connection state.

Preferably, the transmission means is configured to wirelessly transmit the operational state and/or maintenance state using Long Range Wireless Transmitter or Bluetooth or a 5G transmission protocol.

The present disclosure further relates to a method for monitoring a condition of a hydro-mechanical switchgear, as defined by the independent claim 5.

Various embodiments may preferably implement the following features.

Preferably, the at least one measured parameter is transmitted periodically.

Preferably, wireless transmission of the at least one measured parameter is performed using Long Range Wireless Transmitter or Bluetooth or a 5G transmission protocol.

Preferably, the at least one measured pump parameter is processed to generate an operational state and/or maintenance state of the hydro-mechanical switchgear.

Preferably, the operational state and/or maintenance state comprises information on at least one of system pressure, leakage detection, sealing state, piston state, pump state, electrical connection state.

Preferably, wirelessly transmitting the operational state and/or maintenance state is performed using Long Range Wireless Transmitter or Bluetooth or a 5G transmission protocol.

The invention is further described with reference to the figures. Therein,
Fig. 1a to 1c show the working principle of a hydro-mechanical switchgear,
Fig. 2 shows an exemplary graph depicting a correlation between pump starts and maintenance,
Figs. 3 to 5 show examples according to the present disclosure.

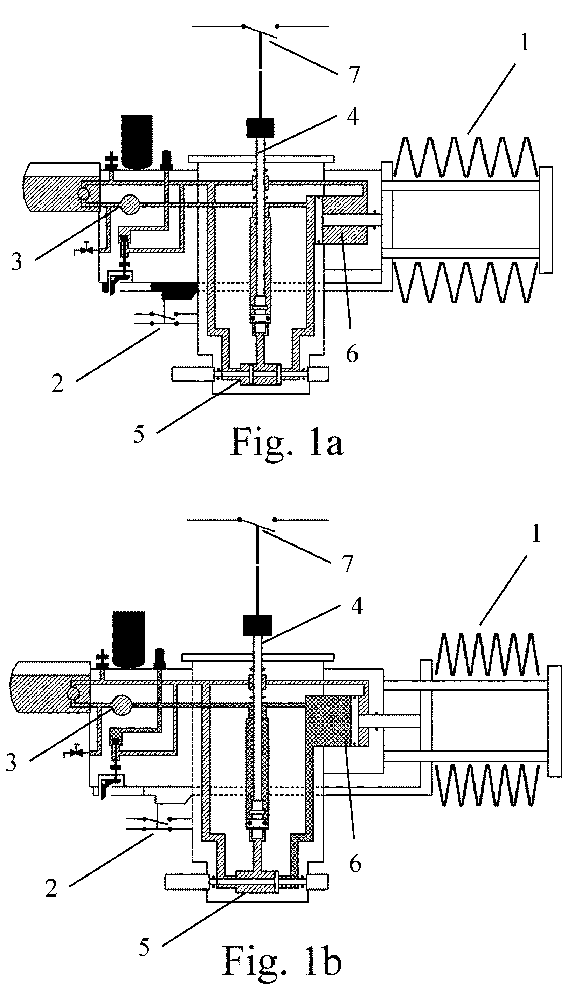

The present disclosure is described using the example of a hydromechanical operating mechanism for a (high voltage) switchgear which may also be referred to as hydro-mechanical switchgear. However, the disclosure may be employed for various types of switchgear or circuit breakers. The working principle and operational states of a hydro-mechanical switchgear are described with reference to Figures 1a - 1c. This hydro-mechanical switchgear depicted in the figures is, however, only exemplary and should not be construed as limiting the scope of the disclosure.

A hydro-mechanical operating mechanism combines a hydraulic operating mechanism with a spring mechanism. In a nutshell, energy is transferred from a hydraulic system to a mechanical system, where it is stored as spring force. Via a release mechanism, the energy stored in the spring may be released to open or close the circuit breaker.

Fig. 1a shows a hydro-mechanical system which is in an open position, i.e. the switch is opened, and where the springs 1 are not charged. The system may comprise a controlling link 2 which may also be referred to as a spring travel switch. A hydraulic pump 3 is provided in order to provide pressure to the hydraulic system. Furthermore, the pump 3 may compensate for slight internal pressure losses by incidental recharging. This may ensure a stable internal pressure. Fig. 1b depicts a state, in which the hydraulic pump 3 is working and charges the springs 1 by compressing the piston 6 through hydraulic pressure. This is indicated by the movement to the right of the piston 6 when compared to Fig. 1a. Furthermore, operation of the pump 3 applies pressure to the operating piston 4, thereby maintaining it in an open state. A changeover valve 5 is provided to separate the high-pressure region, which pressurises the operating piston 4 and the piston 6, from the low-pressure region. As mentioned above, the hydraulic pump 3 may be operated in certain intervals in order to maintain the internal pressure.

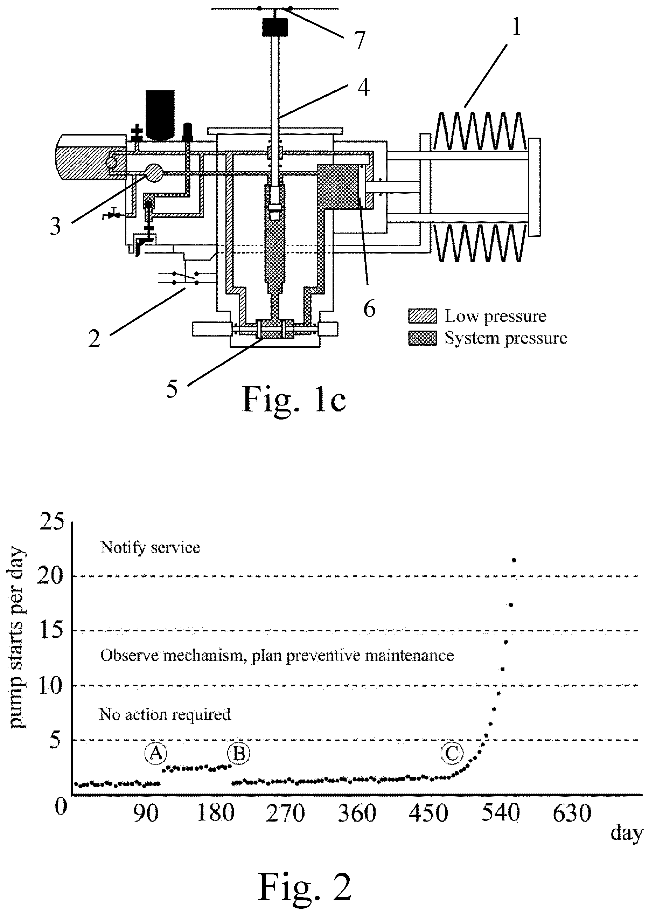

After the system is pressurised, the switch may be transferred into a closed position as depicted in Fig. 1c. This is achieved by operating the changeover valve 5 in a fast movement to apply pressure to the operating piston 4 from below, thereby pushing the operating piston 4 in a vertical direction and closing the switch. Thus, the operating mechanism is in a closed position while the springs 1 are still charged. As long as the high-pressure is applied on the area beneath the operating piston 4, it remains in a closed position. This may constitute the idle position with charged springs and an open switch.

In case the circuit breaker shall be activated in order to open the circuit, the changeover valve 5 is switched to its original position (cf. Figs. 1a and 1b) by activating an opening magnet. Thereby, the pressure applied from below and maintaining the operating piston 4 in the closed position is released, while the springs 1 urge the piston 6 in the left direction. Thus, the operating piston 4 is pressurised from above and the switch is transferred to the open position. The system is then in a state according to Fig. 1a where the operating mechanism is open and the springs are not charged.

As evident from the above description, it is crucial for operation of the hydro-mechanical system to maintain the pressure in the high-pressure regions and detect leakage or faults in good time.

When the system is in its idle state, waiting for the command to operate the circuit breaker, the springs are charged causing a high hydraulic pressure inside the system. In a highly pressurized hydraulic system, however, some internal leakage may occur from high pressure to low pressure regions. This is compensated by operating the pump 3 at a hydraulic pressure slightly below the nominal state. Typically, the pump 3 may be operated 1-5 times in a 24h period and such information relating to pump operation information can provide operational and/or maintenance states.

Internal leakage is also the most common failure cause, indicating either component or sealing failure. Typically, such failure occurs slowly, increasing the number of pump starts and help in determination of maintenance state. Fig. 2 is an exemplary graph showing the pump starts per day on the y-axis, wherein the x-axis is the time axis in days. In this example according to Fig. 2, less than 10 starts per day is normal, i.e. no action is required. 10-20 starts per day leads to observing the mechanism and planning maintenance, and if more than 20 starts per day are noticed, service will be notified and the breaker may possibly be taken out of service. Furthermore, Fig. 2 shows exemplary faults such as an increase in pump starts e.g. caused by a particle in a valve, indicated by the reference sign (A), and a corresponding decrease in pump starts e.g. due to removal of the particle by a switching operation (B). The increase in pump starts at time (C) may indicate a more extensive failure, e.g. caused by severe internal leakage. Such behaviours can be observed with help of data collected by the monitoring device described in the invention and accordingly help in diagnosis and plan maintenance/service schedules and activities.

An increase of pump starts may thus also be due to particles blocking movement of the piston or preventing a sealing from effectively sealing a pressurised region of the system. This may be resolved e.g. by switching operation which removes the blocking particle or contamination from the affected region.

In addition, if no pump start is detected at all, this could also be a trigger for alarm, possibly indicating pump motor or electrical connection failure. This mechanism would allow enough time to react before the system would reach a critical condition.

Thus, the number of pump starts and duration of pump activity may be an indication of the state of the system, in particular leakages or internal contamination of the hydraulic system. The present disclosure provides a device for monitoring a condition of switchgear which is able to non-invasively monitor parameters of the switchgear and may be retrofitted to any suitable system comprising switchgear.

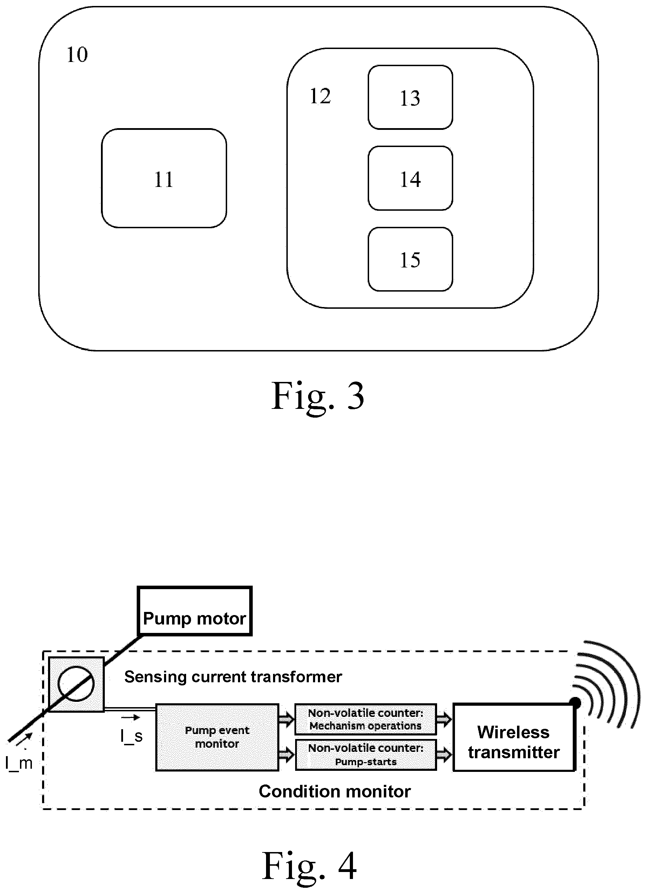

Referring to Fig. 3, the disclosure thus relates to a system 10 comprising switchgear 11 and a device 12 for monitoring a condition of switchgear. The device 12 comprises attachment means 13 for attaching the device to switchgear 11. The attachment means 13 may be formed as any means suitable for retrofittably attaching the device 12 to the switchgear. The attachment means 13 may be a magnet, screws, a belt or any other means. The device 12 further comprises measurement means 14 for measuring at least one parameter of the switchgear 11, wherein the measurement is performed non-invasively. Transmission means 15 are provided for transmitting the at least one measured parameter.

The system 10 is configured to measure pump parameters of hydro-mechanical switchgear. Therefore, the device 12 is preferably attached close to a hydraulic pump 3 of the switchgear 11. The measured pump parameters are: current flowing through the pump, duration of pump operation, frequency of pump operation, vibration of the pump, number of pump starts and magnetic field of the pump. A plurality of the enumerated pump parameters may be simultaneously acquired.

The current flowing through the pump, the vibration of the pump and/or the magnetic field of the pump may also be used to compute the frequency of operation, the number of pump starts in a certain amount of time or the duration of pump operation.

The measurement means 14 is configured to inductively measure a current flowing through the hydraulic pump 3.

The transmission means 15 may be configured to wirelessly transmit the at least one measured parameter using Long Range Wireless Transmitter or Bluetooth or a 5G transmission protocol. The at least one measured parameter may e.g. be periodically transmitted. The transmitted data may for example be centrally acquired and evaluated in order to improve the maintenance data and data on the state of the system. The data may also be anonymously shared. Alternatively, the data may also be evaluated only on a facility or substation level.

The device may also comprise a controller or computing device to process the at least one measured pump parameter. In particular, the controller may be configured to generate an operational state and/or maintenance state of the hydro-mechanical switchgear. The operational state and/or maintenance state may be generated by processing the at least one measured pump parameter. The operational state and/or maintenance state may e.g. comprise information on at least one of operation related parameters of the circuit breaker e.g. electrical connection state, system pressure, leakage detection, sealing state, piston state, pump state and/or conditions/states of other components relating to the circuit breaker. As explained above, information relating to operational state and/or maintenance state may be correlated to the pump data such as flow through the pump, duration of pump operation, frequency of pump operation, vibration of the pump, number of pump starts and magnetic field of the pump. Such correlation is also useful for consistency checks relating to determination of operational and/or maintenance state. The operational state and/or maintenance state may also be transmitted by the transmission means 15.

The controller having a functionality as described above may also be connected to the device. That is, the controller may be provided external from the device. One or more devices may be connected to the controller and the controller may thus process the at least one measured pump parameter for one switchgear or a plurality of switchgears, e.g. per substation.

The controller may also be provided in a cloud or central storage or processing facility to centrally process the gathered data. In any case, the processing may be performed for one device or a plurality of devices and accordingly per device, per substation or for a plurality of substations/facilities to monitor a fleet of switchgears. The controller provided centrally or in a cloud may also receive and process data from adjacent switchgear, other devices (e.g. drives) or other electrical equipment in the substation and correlate received information with the information relating to operational and/or maintenance state by observing specific behaviours and determine corresponding service or maintenance activities for the switchgear connected with the device 12. Further, the controller for observing/predicting/diagnosing behaviours associated with the switchgear connected with the device 12 may also correlate data transmitted by a device 12 and the processed information relating to operational and/or maintenance state determined for the switchgear with information such as electrical load, ambient conditions (temperature, pressure) at the site and observed behaviour information relating to one or more switchgears in a fleet of switchgears installed in one or more substations.

Fig. 4 shows an example according to the present disclosure. In particular, the device 12, i.e. the condition monitor, is attached to the switchgear 11 and is in particular able to monitor activity of the pump or pump motor 3. The device 12 may further comprise a sensing current transformer which feeds an input current to a pump event monitor. Therein, Iₘ may denote the motor current and Iₛ may denote the sensing current. The device 12 may also comprise at least one non-volatile counter for counting mechanism operations and pump starts, respectively. The data from the counter or counters may then be transferred to a wireless transmitter, e. g. a long-range wireless transmitter, which wirelessly transmits the data to a recipient. Any form of wireless transmitter or, alternatively, a tethered transmission may be used with the present disclosure.

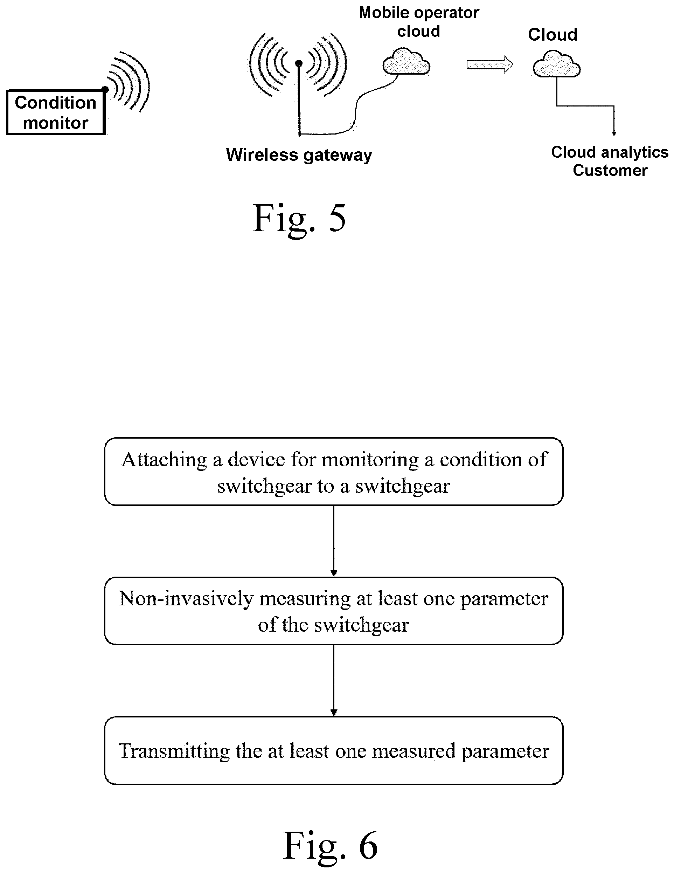

Fig. 5 shows an exemplary configuration of data transfer and evaluation. The condition monitor may correspond to the one depicted in Fig. 4. The data is transmitted in a 24-hour interval to a mobile operator wireless gateway which is connected to a mobile operator cloud. Data may also be transferred to a cloud, where general analytics or customer specific analytics are performed.

The disclosure further relates to a corresponding method as depicted in Fig. 6. In particular, the method comprises attaching a device for monitoring a condition of switchgear to a switchgear and non-invasively measuring at least one parameter of the switchgear. The at least one measured parameter is then transmitted.

The method may preferably be employed for non-invasively measuring at least one parameter of a hydro-mechanical switchgear. The method may further comprise measuring one of current flowing through the pump, duration of pump operation, frequency of pump operation, vibration of the pump, number of pump starts and magnetic field of the pump.

The at least one measured parameter may be transmitted periodically. The at least one measured parameter may be wirelessly transmitted using, e.g., Long Range Wireless Transmitter or Bluetooth or a 5G transmission protocol.

The method preferably further comprises processing the at least one measured pump parameter to generate an operational state and/or maintenance state of the hydro-mechanical switchgear. Preferably, the operational state and/or maintenance state comprises information on at least one of system pressure, leakage detection, sealing state, piston state, pump state and electrical connection state. The operational state and/or maintenance state may also be wirelessly transmitted using, e.g., Long Range Wireless Transmitter or Bluetooth or a 5G transmission protocol.

The present disclosure may further relate to a program carried out by a computer implementing the above described method.

The present disclosure hence provides a simple and reliable system, device and method for monitoring a condition of a hydro-mechanical switchgear. The device can be attached to and can be used to monitor e.g. a frequency and duration of operation of a hydro-mechanical switchgear pump. This solution can be retrofitted and easily employed in a hydro-mechanical switchgear irrespective of the internal structure. No circuitry or internal wiring has to be adapted and the system must not be taken off the grid to install the monitoring device. The gathered data can be indicative of the state of the system such as internal leakage, system pressure, sealing state, piston state, pump state and electrical connection state and thus facilitate maintenance and avoid downtime or even system failure of the system.

Other aspects, features, and advantages will be apparent from the summary above, as well as from the description that follows, including the figures and the claims.

While the invention has been illustrated and described in detail in the drawings and foregoing description, such illustration and description are to be considered illustrative or exemplary and not restrictive. It will be understood that changes and modifications may be made by those of ordinary skill within the scope of protection, which is defined by the following claims.

Furthermore, in the claims the word "comprising" does not exclude other elements or steps, and the indefinite article "a" or "an" does not exclude a plurality. A single unit may fulfil the functions of several features recited in the claims. The terms "essentially", "about", "approximately" and the like in connection with an attribute or a value particularly also define exactly the attribute or exactly the value, respectively. Any reference signs in the claims should not be construed as limiting the scope.

## Claims

1. A device (12) for monitoring a condition of a hydro-mechanical switchgear (11), wherein
the device (12) comprises:
attachment means (13) for attaching the device (12) to the hydro-mechanical switchgear (11);
measurement means (14) for measuring at least one pump parameter of the hydro-mechanical switchgear (11), wherein the measurement is performed non-invasively;
transmission means (15) for transmitting the at least one measured parameter;
wherein the device (12) comprises or is attached to a controller for processing the at least one measured parameter,
**characterised in that**
the measurement means (14) is configured to measure a current flowing through the pump, wherein the current is measured inductively, duration of pump operation, frequency of pump operation, vibration of the pump, number of pump starts and magnetic field of the pump as the pump parameter.

2. Device (12) according to claim 1, wherein the at least one measured parameter is periodically transmitted.

3. Device (12) according to any one of the preceding claims, wherein the transmission means (15) is configured to wirelessly transmit the at least one measured parameter using Long Range Wireless Transmitter or Bluetooth or a 5G transmission protocol.

4. Device (12) according to one of the preceding claims, wherein the controller is configured to process the at least one measured pump parameter to generate an operational state and/or maintenance state of the hydro-mechanical switchgear (11),
wherein preferably the operational state and/or maintenance state comprises information on at least one of system pressure, leakage detection, sealing state, piston state, pump state, electrical connection state, and
wherein preferably the transmission means (15) is configured to wirelessly transmit the operational state and/or maintenance state using Long Range Wireless Transmitter or Bluetooth or a 5G transmission protocol.

5. Method for monitoring a condition of a hydro-mechanical switchgear (11), the method comprising:
attaching a device (12) for monitoring a condition of switchgear to the hydro-mechanical switchgear (11),
measuring at least one pump parameter of the hydro-mechanical switchgear (11), wherein the measuring is performed non-invasively;
transmitting the at least one measured pump parameter;
processing the at least one measured pump parameter,
**characterised in that**
measuring comprises measuring a current flowing through the pump, wherein the current is measured inductively, duration of pump operation, frequency of pump operation, vibration of the pump, number of pump starts and magnetic field of the pump.

6. Method according to claim 5, further comprising periodically transmitting the at least one measured parameter.

7. Method according to any one of claims 5 or 6, further comprising wirelessly transmitting the at least one measured parameter using Long Range Wireless Transmitter or Bluetooth or a 5G transmission protocol.

8. Method according to one of claims 5 to 7, further comprising processing the at least one measured pump parameter to generate an operational state and/or maintenance state of the hydro-mechanical switchgear (11),
wherein preferably the operational state and/or maintenance state comprises information on at least one of system pressure, leakage detection, sealing state, piston state, pump state, electrical connection state, and
preferably wirelessly transmitting the operational state and/or maintenance state using Long Range Wireless Transmitter or Bluetooth or a 5G transmission protocol.

## Patentansprüche

1. Vorrichtung (12) zum Überwachen eines Zustands einer hydromechanischen Schaltanlage (11), wobei die Vorrichtung (12) Folgendes umfasst:
ein Befestigungsmittel (13) zum Befestigen der Vorrichtung (12) an der hydromechanischen Schaltanlage (11);
ein Messmittel (14) zum Messen mindestens eines Pumpenparameters der hydromechanischen Schaltanlage (11), wobei die Messung nicht-invasiv durchgeführt wird;
ein Übertragungsmittel (15) zum Übertragen des mindestens einen gemessenen Parameters;
wobei die Vorrichtung (12) eine Steuerung zum Verarbeiten des mindestens einen gemessenen Parameters umfasst oder daran befestigt ist,
**dadurch gekennzeichnet, dass**
das Messmittel (14) dazu ausgelegt ist, einen durch die Pumpe fließenden Strom, wobei der Strom induktiv gemessen wird, eine Dauer eines Pumpenbetriebs, eine Frequenz eines Pumpenbetriebs, eine Vibration der Pumpe, eine Anzahl von Pumpenstarts und ein Magnetfeld der Pumpe als den Pumpenparameter zu messen.

2. Vorrichtung (12) nach Anspruch 1, wobei der mindestens eine gemessene Parameter periodisch übertragen wird.

3. Vorrichtung (12) nach einem der vorhergehenden Ansprüche, wobei das Übertragungsmittel (15) dazu ausgelegt ist, den mindestens einen gemessenen Parameter unter Verwendung eines drahtlosen Langstreckensenders oder Bluetooth oder eines 5G-Übertragungsprotokolls drahtlos zu übertragen.

4. Vorrichtung (12) nach einem der vorhergehenden Ansprüche, wobei die Steuerung dazu ausgelegt ist, den mindestens einen gemessenen Pumpenparameter zu verarbeiten, um einen Betriebszustand und/oder Wartungszustand der hydromechanischen Schaltanlage (11) zu erzeugen,
wobei vorzugsweise der Betriebszustand und/oder der Wartungszustand Informationen über mindestens eines eines Systemdrucks, einer Leckagedetektion, eines Abdichtungszustands, eines Kolbenzustands, eines Pumpenzustands, eines Zustands einer elektrischen Verbindung umfasst, und
wobei vorzugsweise das Übertragungsmittel (15) dazu ausgelegt ist, den Betriebszustand und/oder Wartungszustand unter Verwendung eines drahtlosen Langstreckensenders oder Bluetooth oder eines 5G-Übertragungsprotokolls drahtlos zu übertragen.

5. Verfahren zum Überwachen eines Zustands einer hydromechanischen Schaltanlage (11), wobei das Verfahren Folgendes umfasst:
Befestigen einer Vorrichtung (12) zum Überwachen eines Zustands der Schaltanlage an der hydromechanischen Schaltanlage (11),
Messen mindestens eines Pumpenparameters der hydromechanischen Schaltanlage (11), wobei das Messen nicht-invasiv durchgeführt wird;
Übertragen des mindestens einen gemessenen Pumpenparameters;
Verarbeiten des mindestens einen gemessenen Pumpenparameters,
**dadurch gekennzeichnet, dass**
das Messen Messen eines durch die Pumpe fließenden Stroms, wobei der Strom induktiv gemessen wird, einer Dauer eines Pumpenbetriebs, einer Frequenz eines Pumpenbetriebs, einer Vibration der Pumpe, einer Anzahl von Pumpenstarts und eines Magnetfelds der Pumpe umfasst.

6. Verfahren nach Anspruch 5, ferner umfassend periodisches Übertragen des mindestens einen gemessenen Parameters.

7. Verfahren nach einem der Ansprüche 5 oder 6, ferner umfassend drahtloses Übertragen des mindestens einen gemessenen Parameters unter Verwendung eines drahtlosen Langstreckensenders oder Bluetooth oder eines 5G-Übertragungsprotokolls.

8. Verfahren nach einem der Ansprüche 5 bis 7, ferner umfassend Verarbeiten des mindestens einen gemessenen Pumpenparameters, um einen Betriebszustand und/oder Wartungszustand der hydromechanischen Schaltanlage (11) zu erzeugen,
wobei vorzugsweise der Betriebszustand und/oder der Wartungszustand Informationen über mindestens eines eines Systemdrucks, einer Leckagedetektion, eines Abdichtungszustands, eines Kolbenzustands, eines Pumpenzustands, eines Zustands einer elektrischen Verbindung umfasst, und
vorzugsweise drahtloses Übertragen des Betriebszustands und/oder Wartungszustands unter Verwendung eines drahtlosen Langstreckensenders oder Bluetooth oder eines 5G-Übertragungsprotokolls.

## Revendications

1. Dispositif (12) destiné à surveiller l'état d'un appareillage de commutation hydro-mécanique (11), le dispositif (12) comprenant :
un moyen de fixation (13) destiné à fixer le dispositif (12) à l'appareillage de commutation hydro-mécanique (11) ;
un moyen de mesure (14) destiné à mesurer au moins un paramètre de pompe de l'appareillage de commutation hydro-mécanique (11), la mesure étant effectuée de manière non invasive ;
un moyen de transmission (15) destiné à transmettre l'au moins un paramètre mesuré ;
le dispositif (12) comprenant ou étant fixé à un dispositif de commande destiné à traiter l'au moins un paramètre mesuré,
**caractérisé en ce que**
le moyen de mesure (14) est conçu pour mesurer un courant passant à travers la pompe, le courant étant mesuré de manière inductive, la durée de fonctionnement de la pompe, la fréquence de fonctionnement de la pompe, la vibration de la pompe, le nombre de démarrages de la pompe et le champ magnétique de la pompe en tant que paramètre de pompe.

2. Dispositif (12) selon la revendication 1, l'au moins un paramètre mesuré étant transmis périodiquement.

3. Dispositif (12) selon l'une quelconque des revendications précédentes, le moyen de transmission (15) étant conçu pour transmettre sans fil l'au moins un paramètre mesuré à l'aide d'un émetteur sans fil longue portée ou du Bluetooth ou d'un protocole de transmission 5G.

4. Dispositif (12) selon l'une des revendications précédentes, le dispositif de commande étant conçu pour traiter l'au moins un paramètre de pompe mesuré pour générer un état de fonctionnement et/ou un état de maintenance de l'appareillage de commutation hydro-mécanique (11),
de préférence l'état de fonctionnement et/ou l'état de maintenance comprenant des informations sur au moins l'un parmi la pression du système, la détection de fuite, l'état d'étanchéité, l'état du piston, l'état de la pompe, l'état de la connexion électrique, et
de préférence le moyen de transmission (15) étant conçu pour transmettre sans fil l'état de fonctionnement et/ou l'état de maintenance à l'aide d'un émetteur sans fil longue portée ou du Bluetooth ou d'un protocole de transmission 5G.

5. Procédé de surveillance de l'état d'un appareillage de commutation hydro-mécanique (11), le procédé comprenant les étapes consistant à :
fixer un dispositif (12) destiné à surveiller l'état d'un appareillage de commutation à l'appareillage de commutation hydro-mécanique (11),
mesurer au moins un paramètre de pompe de l'appareillage de commutation hydro-mécanique (11), la mesure étant effectuée de manière non invasive ;
transmettre l'au moins un paramètre de pompe mesuré,
traiter l'au moins un paramètre de pompe mesuré,
**caractérisé en ce que**
la mesure comprend l'étape consistant à mesurer un courant passant à travers la pompe, le courant étant mesuré de manière inductive, la durée de fonctionnement de la pompe, la fréquence de fonctionnement de la pompe, la vibration de la pompe, le nombre de démarrages de la pompe et le champ magnétique de la pompe.

6. Procédé selon la revendication 5, comprenant en outre l'étape consistant à transmettre périodiquement l'au moins un paramètre mesuré.

7. Procédé selon l'une quelconque des revendications 5 ou 6, comprenant en outre l'étape consistant à transmettre sans fil l'au moins un paramètre mesuré à l'aide d'un émetteur sans fil longue portée ou du Bluetooth ou d'un protocole de transmission 5G.

8. Procédé selon l'une des revendications 5 à 7, comprenant en outre les étapes consistant à traiter l'au moins un paramètre de pompe mesuré pour générer un état de fonctionnement et/ou un état de maintenance de l'appareillage de commutation hydro-mécanique (11),
de préférence l'état de fonctionnement et/ou l'état de maintenance comprenant des informations sur au moins l'un parmi la pression du système, la détection de fuite, l'état d'étanchéité, l'état du piston, l'état de la pompe, l'état de la connexion électrique, et
de préférence à transmettre sans fil l'état de fonctionnement et/ou l'état de maintenance à l'aide d'un émetteur sans fil longue portée ou du Bluetooth ou d'un protocole de transmission 5G.
